(19) Europäisches Patentamt / European Patent Office / Office européen des brevets

(11) **EP 2 803 085 B1**

(12) **FASCICULE DE BREVET EUROPEEN**

(45) Date de publication et mention de la délivrance du brevet:
**10.04.2019 Bulletin 2019/15**

(21) Numéro de dépôt: **13700512.0**

(22) Date de dépôt: **08.01.2013**

(51) Int Cl.:
***H01L 23/373*** *(2006.01)*     ***H01L 23/427*** *(2006.01)*

(86) Numéro de dépôt international:
**PCT/EP2013/050217**

(87) Numéro de publication internationale:
**WO 2013/104620 (18.07.2013 Gazette 2013/29)**

(54) **DISPOSITIF DE GESTION THERMIQUE PASSIF**

PASSIVE WÄRMEVERWALTUNGSVORRICHTUNG

PASSIVE THERMAL MANAGEMENT DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.01.2012 FR 1250240**

(43) Date de publication de la demande:
**19.11.2014 Bulletin 2014/47**

(73) Titulaire: **Commissariat à l'Énergie Atomique et aux Énergies Alternatives**
**75015 Paris (FR)**

(72) Inventeurs:
• **GAVILLET, Jérôme**
 **F-38120 Saint-Egreve (FR)**
• **DIJON, Jean**
 **F-38800 Champagnier (FR)**

(74) Mandataire: **Brevalex**
 **95, rue d'Amsterdam**
 **75378 Paris Cedex 8 (FR)**

(56) Documents cités:
**US-A1- 2003 227 732**    **US-A1- 2006 231 970**
**US-A1- 2007 138 623**    **US-A1- 2007 235 847**
**US-A1- 2008 128 122**    **US-A1- 2008 174 963**

## Description

### DOMAINE TECHNIQUE ET ART ANTÉRIEUR

La présente invention se rapporte à un dispositif de gestion thermique passif, pouvant par exemple être utilisé pour le refroidissement de composants électroniques.

Dans les systèmes électroniques, sont confinés un nombre croissant de fonctionnalités. On cherche simultanément à réduire la taille de ces composants. Cette tendance conduit à une dissipation de chaleur croissante par unité de volume (ou de masse) de composant.

Les moyens traditionnels de refroidissement, tels que la convection d'air qu'elle soit naturelle ou forcée, ne sont pas suffisants pour évacuer cette chaleur.

Outre la quantité plus importante de chaleur à évacuer se pose le problème de l'évacuation de la chaleur en mode transitoire, lorsque le flux de chaleur est relativement élevé et la durée de la charge est relativement courte.

Il a été envisagé d'intégrer des micro-canaux au sein des composants, associés à un système externe et actif de circulation d'un fluide caloporteur. Cette technique est relativement efficace pour extraire la chaleur tout en limitant la résistance thermique aux contacts. Le système externe et actif est par exemple formé par une micropompe. Or cette technique offre un certain encombrement, en outre des problèmes de fiabilité peuvent se poser au cours du temps et une maintenance est requise.

La mise en oeuvre de fluides réfrigérant a pour avantage d'utiliser une chaleur latente de vaporisation lors d'un changement de phase, en supplément d'un refroidissement convectif très efficace. Ceci conduit à une dissipation de puissance thermique supérieure tout en maintenant la température de surface relativement faible et uniforme. Par exemple, pour une jonction de puce à 85 °C, l'ébullition en vase d'un fluide caloporteur type fluorocarbone FC72 permet de dissiper des flux de chaleur de l'ordre de 50 W/cm$^2$ alors qu'un radiateur refroidi à l'air ne peut dissiper qu'une puissance de 0,1 W/cm$^2$, à dimensions équivalentes. Cependant, la dissipation de chaleur par changement de phase demeure limitée pour les charges thermiques élevées. En effet, le seuil maximal de dissipation par ébullition ou évaporation dépend des propriétés thermo-physiques du fluide caloporteur, du régime hydrodynamique d'écoulement diphasique et des conditions d'énergie de surface et reste limité par le flux de chaleur critique lequel conduit à un assèchement irréversible de la surface et à la chute spontanée du transfert de chaleur au travers de celle-ci.

Le document US 2006/0231970 décrit un matériau d'interface thermique destiné à être disposé entre une source de chaleur et un dispositif de dissipation de chaleur. Le matériau comporte des nanotubes de carbone noyés dans une matrice en un matériau à changement de phase, comme la paraffine. Les nanotubes de carbones s'étendent de manière discrète et longitudinalement entre la source de chaleur et le dispositif de dissipation de la chaleur. Les extrémités des nanotubes font saillie des surfaces du matériau d'interface thermique, et sont en contact avec la source de chaleur et le dispositif de dissipation thermique, formant un chemin de conduction thermique entre la source de chaleur et le dispositif de dissipation de la chaleur. Le transfert thermique entre la source et le dispositif de dissipation thermique se fait principalement via les nanotubes. Lorsque le matériau à changement de phase passe de l'état solide à l'état liquide sous l'effet de la chaleur émise par la source, celui-ci remplit l'espace entre la source de chaleur et le dispositif de dissipation thermique et assure une interface thermique entre la source de chaleur et le dispositif de dissipation thermique.

Le document US2008/174963 décrit un dispositif d'échange thermique mettant en oeuvre un changement de phase liquide/vapeur, celui-ci comportant des réseaux de nanotubes et du liquide présent entre les nanotubes ; le liquide s'évapore grâce à la chaleur transmise par les nanotubes.

Le matériau d'interface thermique a une épaisseur de l'ordre du micromètre pour offrir une certaine souplesse. Ce matériau permet une évacuation efficace de la chaleur en régime nominal, i.e. lorsque le flux de chaleur est relativement faible et la durée de la charge est relativement longue. Cependant en régime transitoire, lorsque le flux de chaleur est relativement élevée et la durée de la charge est relativement courte, ce matériau ne permet plus une gestion thermique efficace.

### EXPOSÉ DE L'INVENTION

C'est par conséquent un but de la présente invention d'offrir un dispositif de gestion thermique passif efficace pour évacuer la chaleur à la fois en régime nominal et en régime transitoire.

Le but de la présente invention est atteint par un dispositif de gestion thermique comportant des cellules contenant un matériau à changement de phase solide/liquide, les parois des cellules étant formées par des nanotubes de carbone, les nanotubes formant un court-circuit thermique entre la source de chaleur et le dissipateur thermique.

Grâce à leur très bonne conductivité thermique, les nanotubes assurent une évacuation de la chaleur en régime nominal par conduction. En régime transitoire, le matériau à changement de phase par passage de l'état solide à l'état liquide assure l'absorption temporaire de la chaleur. De préférence, la taille des cellules est relativement faible, de sorte que les parois en nanotubes des cellules permettent de distribuer de manière contrôlée et prédéfinie la chaleur au coeur du matériau à changement de phase.

En régime nominal, l'évacuation de la chaleur se fait donc principalement par conduction au moyen des nanotubes, et en régime transitoire le stockage de la chaleur se fait principalement par changement de phase, puis son évacuation se fait par conduction au moyen des nanotubes.

De manière très avantageuse, les nanotubes sont en contact les uns avec les autres de sorte que les parois des cellules soient en matériau dense, offrant une meilleure conductivité thermique dans le sens latérale et un volume disponible pour le matériau à changement de phase plus important.

La présente invention a alors pour objet un dispositif de gestion thermique comportant une première face destinée à être en contact avec une source chaude (SC) et une deuxième face opposée à la première destinée à être en contact avec une source froide, au moins un réseau de cellules remplies d'un matériau à changement de phase solide/liquide disposé entre la première et la deuxième face, les cellules comportant des parois formées de nanotubes de carbone, lesdits nanotubes s'étendant sensiblement de la première à la deuxième face et reliant thermiquement la première face à la deuxième face.

De préférence, les parois des cellules forment une cloison latérale continue.

De manière très avantageuse, les parois des cellules sont formées des nanotubes en contact de sorte à former un matériau dense.

La dimension transversale de chaque cellule est de préférence inférieure ou égale à la distance du front de fusion, la distance du front de fusion étant de l'ordre de $\sqrt{\dfrac{2.k.\Delta T.t}{L}}$, k étant la conduction thermique du matériau à changement de phase, L étant la chaleur latente de fusion du matériau à changement de phase, $\Delta T$ étant la différence de température entre la température de la paroi d'une cellule lors d'une surcharge thermique et la température de changement de phase du matériau à changement de phase, et t étant le temps.

Dans un mode de réalisation, le dispositif comporte un support muni d'au moins une cavité et un capot obturant ladite cavité, ladite cavité comportant un réseau de cellules en nanotubes de carbone remplies de matériau à changement de phase.

Avantageusement, un matériau conducteur thermique ductile peut être interposé entre le capot et le réseau de cellules ou entre le fond de la cavité et le réseau de cellules.

Dans un exemple de réalisation, le réseau de cellules est solidaire du capot.

Dans un autre exemple de réalisation, le réseau de cellules est solidaire du fond de la cavité.

Le dispositif de gestion thermique selon l'invention peut comporter plusieurs cavités.

Par exemple, l'aire de la ou les cavités est comprise entre 1000 $\mu m^2$ et 10 $cm^2$,

Le support peut avoir une épaisseur comprise entre 0,5 mm et 1 mm, de préférence égal à 750 $\mu m$, et la ou les cavités 16 peuvent avoir une profondeur comprise entre 50 $\mu m$ et 500 $\mu m$.

La présente invention a également pour objet un système électronique comportant au moins un composant électronique formant une source de chaleur, au moins un dispositif d'évacuation de la chaleur formant une source froide et au moins un dispositif de gestion thermique selon l'invention, le composant électronique étant en contact thermique avec la première face du dispositif de gestion thermique et le dispositif d'évacuation de la chaleur étant en contact thermique avec la deuxième face.

La présente invention a également pour objet un procédé de fabrication d'un dispositif de gestion thermique selon l'invention, comportant les étapes :

a) définition du motif du réseau de cellules sur un substrat par dépôt de résine et lithographie de celle-ci,
b) dépôt d'une couche de catalyseur,
c) retrait de la résine,
d) croissance des nanotubes de carbone, par dépôt chimique en phase vapeur,
e) remplissage des cellules avec le matériau à changement de phase.

Le catalyseur peut être du fer ou un système bicouche aluminium et fer.

Avantageusement, le procédé de fabrication comporte une étape de compactage de nanotubes de carbone par immersion dans une solution d'alcool du réseau de cellules et séchage à l'air.

Le procédé de fabrication peut comporter, préalablement au étapes a) à d), les étapes de réalisation de une ou plusieurs cavités dans un support, la ou lesdites cavités recevant un réseau de cellules, et après l'étape d) de fermeture de la ou des cavités par un capot.

Le substrat peut être formé par le fond de la ou des cavités, les étapes a) à d) peuvent alors avoir lieu sur le fond de la ou des cavités.

Avantageusement, le procédé de fabrication peut comporter une étape de dépôt d'une couche de matériau conducteur thermique ductile sur le fond de la ou des cavités destinée à être orientée vers l'intérieur de la cavité.

Le substrat peut être formé par le capot et les étapes a) à d) peuvent alors avoir lieu sur le capot. Avantageusement, le procédé de fabrication peut comporter une étape de dépôt d'une couche de matériau conducteur thermique ductile sur une face de capot destinée à être orientée vers l'intérieur de la cavité.

## BRÈVE DESCRIPTION DES DESSINS

La présente invention sera mieux comprise à l'aide de la description qui va suivre et des dessins en annexe, sur lesquels :

- les figures 1A et 1B sont des vues en coupe longitudinale et transversale respectivement d'une représentation schématique d'un exemple de réalisation d'un dispositif de gestion thermique selon l'invention,
- la figure 1C est une vue en coupe longitudinale d'un autre exemple de dispositif de gestion thermique en contact avec plusieurs sources chaudes,
- les figures 2A et 2B sont des représentations schématiques d'un exemple d'étapes de réalisation du dispositif selon l'invention,

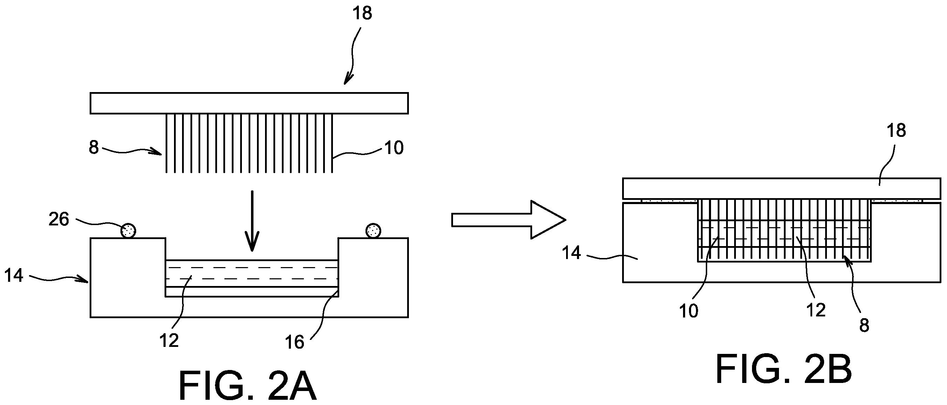

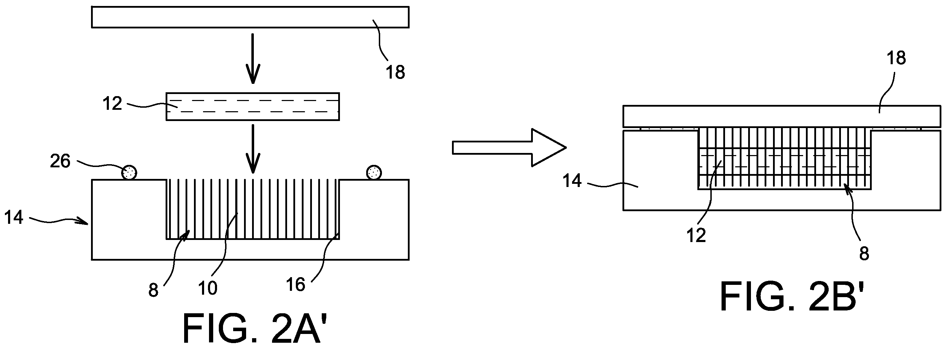

- les figures 2A' et 2B' sont des représentations schématiques d'un autre exemple d'étapes de réalisation du dispositif selon l'invention,
- les étapes 3A à 3E sont des représentations schématiques d'étapes de réalisation du réseau de cellules en nanotubes de carbone,

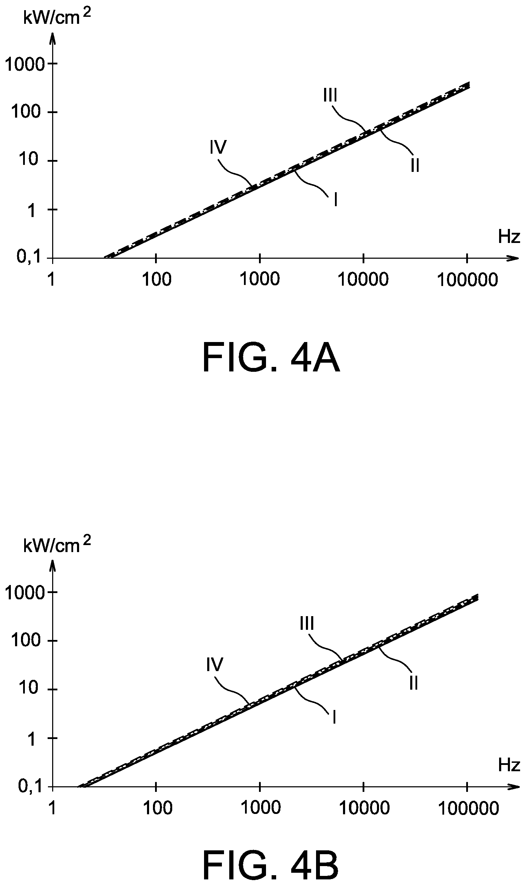

- les figures 4A à 4D sont des représentations graphiques de la densité surfacique de puissance stockable en fonction de la fréquence des charges thermiques pour quatre matériaux à changement de phase différents, l'épaisseur de matériau à changement de phase étant différente pour chaque représentation graphique,

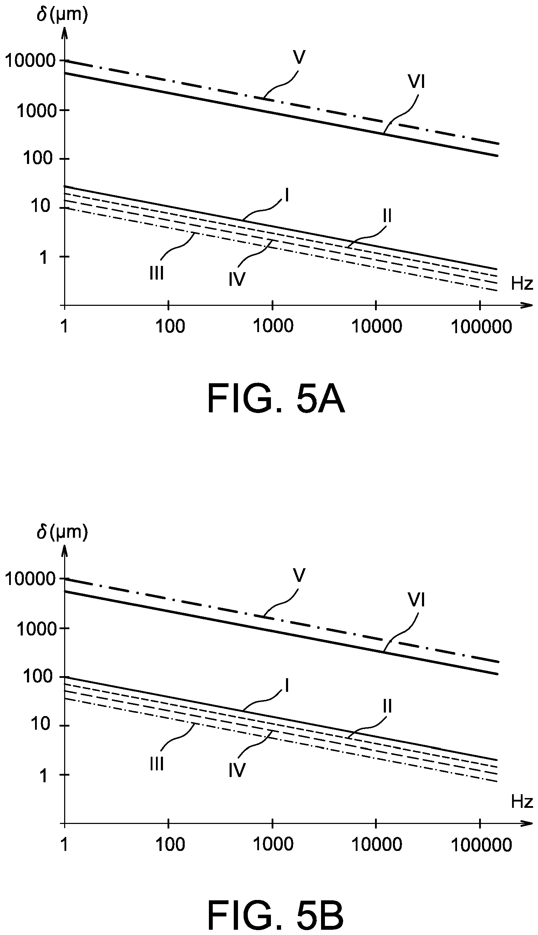

- les figures 5A à 5C sont des représentations graphiques de la profondeur moyenne de pénétration thermique en fonction de la fréquence des charges thermiques dans quatre matériaux à changement de phase différents, dans le cuivre et dans les nanotubes de carbone.

## EXPOSÉ DÉTAILLÉ DE MODES DE RÉALISATION PARTICULIERS

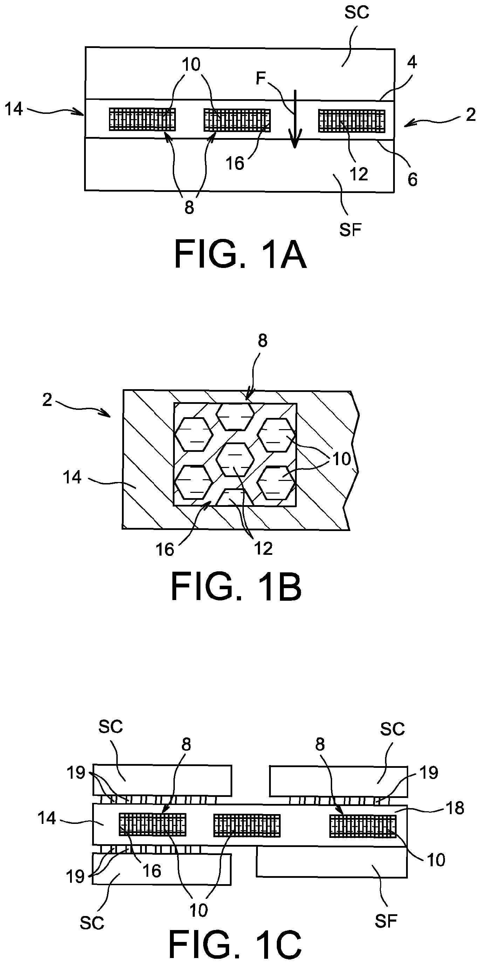

Sur les figures 1A et 1B, on peut voir représenté schématiquement un exemple de réalisation d'un dispositif de gestion thermique 2 disposé une source chaude SC et une source froide SF.

Par exemple, la source chaude SC est un système électronique et la source froide SF est un radiateur à ailettes.

Le dispositif de forme sensiblement plane comporte une première face 4 destinée à être en contact avec la source chaude SC, et une deuxième face 6 opposée à la première face 4 et destinée à être en contact avec la source froide.

Le dispositif comporte un support 14 conducteur thermique, par exemple en silicium monocristallin, dans lequel est réalisée une pluralité de cavités 16 débouchant dans l'une des faces du support 14. Chacune des cavités 16 contient un réseau de cellules 8 en nanotubes de carbone et du matériau à changement de phase. Chaque cavité 16 est fermée par un capot 18. La première face 4 est formée par le capot 18 et la deuxième face 6 par le fond du support 14.

Le dispositif comporte également, situé entre ses deux faces 4, 6, plusieurs réseaux de cellules 8 logés dans des cavités 16. Les cellules sont délimitées par des parois 10 latérales fermées. Les parois 10 s'étendent sensiblement selon la direction du flux thermique F schématisé par une flèche. Le dispositif comporte également un matériau à changement de phase 12 disposé dans les cellules. Les parois 10 sont réalisées en nanotubes de carbone, qui présentent un coefficient de conductivité thermique très élevé, comprise par exemple entre 6 W.cm-1.K$^{-1}$ à 20 W.cm-1.K$^{-1}$.

Chaque extrémité du réseau de cellules 8, dans la direction des nanotubes de carbone, est en contact thermique avec le fond de la cavité 16 et le capot 18. Par exemple, la longueur des nanotubes est donc proche de la profondeur des cavités 16. Dans un exemple avantageux, un matériau conducteur thermique offrant une certaine ductilité, par exemple un métal tel que le titane, le cuivre, l'or... est disposé entre le capot 18 et les nanotubes de carbones de sorte à assurer un bon contact thermique, tout en offrant une certaine tolérance dans la réalisation des nanotubes.

Comme nous le verrons par la suite, les nanotubes peuvent être réalisés directement sur le capot 18 par croissance sur une face de celui-ci ou dans la cavité 16, par croissance sur le fond de celle-ci. En alternative, on peut envisager de réaliser un ensemble indépendant formé d'un réseau de cellules en nanotubes de carbone et de matériau changement de phase solide. Cet ensemble est manipulable et un ensemble serait disposé dans chacune des cavités.

De manière très avantageuse, les parois 10 sont réalisées de telle sorte que les nanotubes collapsent et forment un matériau dense dans lequel les nanotubes sont en contact par leur surface latérale.

L'épaisseur des parois est alors réduite, ce qui augmente le volume des cellules et donc le volume disponible pour le matériau à changement de phase. En outre, la conductivité thermique des parois est également augmentée.

Par exemple le facteur de compaction est compris entre 2 et 10 en fonction de la densité initiale des parois.

Sur la figure 1B, on peut voir un détail du dispositif de la figure 1A en coupe transversale et en particulier une vue de dessus d'un réseau de cellules en forme de nid d'abeille. Cependant cette forme n'est pas exclusive, et un réseau sous forme de cellules carrées ou rectangulaires ne sort pas du cadre de la présente invention. La structure en nid d'abeille présente l'avantage d'offrir une isotropie thermique dans le plan.

Dans l'exemple représenté, les cellules ont toutes la même taille, cependant on pourrait prévoir des cellules de différentes tailles et/ou différentes formes au sein du même dispositif de gestion thermique passif.

De préférence, la section des cellules est choisie de telle sorte qu'en régime transitoire tout le matériau à changement de phase soit fondu, ce qui permet d'optimiser la taille du dispositif et la quantité de matériau à changement de phase mis en oeuvre.

Le matériau à changement de phase est choisi de sorte qu'il passe de l'état solide à l'état liquide lors d'une surcharge thermique de la source chaude SC. Par exemple, pour un composant électronique, sa température d'opération, appelée température nominale, est de l'ordre de 90°C, la température de changement de phase solide/liquide du matériau à changement de phase est alors supérieure à 90°C. Dans le tableau ci-dessous sont données des exemples de matériau à changement de phase adaptés à une telle application. Les températures de changement de phase sont rassemblées dans la deuxième colonne.

| PCM | T (°C) | J/g | Densité (Kg/m³) | KJ/cm³ | Chaleur spécifique (j/g.K) | ΔV (%) | Conductivité thermique (W/K.m) | Diffusivité (m²/s) |
|---|---|---|---|---|---|---|---|---|
| Erythriol | 118 | 340 | 1480 | 0,5 | 1,38 | 13,8% | 2,64 | 1,29E-06 |
| PlusICE X180 | 180 | 301 | 1330 | 0,4 | 1,38 | 9,0% | 0,99 | 5,41E-07 |
| A164 | 164 | 306 | 1500 | 0,5 | 1,38 | 10,0% | 0,20 | 9,66E-08 |
| H110 | 110 | 243 | 2145 | 0,5 | 2,41 | 10,0% | 0,45 | S,70E-08 |

Sur la figure 1C, on peut voir un autre exemple de réalisation du dispositif de gestion thermique selon l'invention. Celui-ci est destiné à être en contact avec plusieurs sources chaudes SC. En outre, des interconnexions 19 TSV ("Through-Silicon Via" en terminologie anglo-saxonne) sont réalisées entre les sources chaudes par exemple par des dispositifs microélectronique de type *puce électronique* et le dispositif d'échange thermique.

Nous allons maintenant expliquer le fonctionnement du dispositif d'échange thermique de la figure 1A. Le fonctionnement de la figure 1C est similaire à celui de la figure 1A.

En régime nominal : la charge correspond au fonctionnement normal de la source de chaleur SC. Le flux de chaleur est relativement faible, par exemple inférieur à 1 W/cm², et la durée de charge est relativement élevée, par exemple supérieure à 10 secondes. La chaleur est transmise à la source froide SF par les parois du réseau de cellules 8 en nanotubes par conduction. La température du dispositif de gestion thermique est alors inférieure à la température de changement de phase du matériau à changement, qui reste donc à l'état solide : le stockage thermique dans le matériau à changement de phase n'est alors pas activé en régime nominal.

En régime transitoire : la charge correspond au fonctionnement anormal de la source de chaleur SC. Le flux de chaleur est relativement élevé, supérieur à 1 W/cm², et la durée de charge est relativement courte, par exemple inférieure à 10 secondes. Le flux thermique conduit à une élévation locale de température telle que le matériau à changement passe à l'état liquide : le stockage thermique est activé. La chaleur est transmise au matériau à changement de phase par les parois en nanotubes qui entoure le matériau à changement de phase.

A la fin du régime transitoire, le matériau à changement 10 se solidifie en rendant sa chaleur latente au système qui se dissipe par conduction vers la source froide, la température devient simultanément inférieure à celle du changement de phase et le dispositif de gestion thermique est à nouveau disponible pour le régime transitoire suivant. Le stockage thermique est désactivé.

Dans l'exemple de fonctionnement décrit, le régime nominal et le régime transitoire ont lieu à des instants différents, cependant on peut envisager qu'ils aient lieu simultanément, par exemple dans le cas où le dispositif est en contact avec plusieurs sources chaudes. Le dispositif selon l'invention permet de gérer thermiquement et simultanément des charges thermiques nominales et/ou transitoires.

Sur les figures 4A à 4D, on peut voir représentée la densité surfacique de puissance stockable DS en kW/cm2 par différents matériaux à changement de phase pour différentes épaisseurs de matériau à changement de phase en fonction de la fréquence des charges thermiques en Hz, ce qui représente leur capacité de stockage.

Il est considéré une température nominale du composant à refroidir de l'ordre de 90°C.

La densité surfacique de puissance stockable est le produit de la densité surfacique d'énergie stockable par la fréquence de la surcharge thermique.

La densité surfacique d'énergie stockable est la somme de la chaleur latente disponible sur une épaisseur H de matériau à changement de phase et de la chaleur sensible disponible pour le même matériau à changement de phase sur l'intervalle de température : $T_{max}$ - $T_{nominale}$, où $T_{max}$ est la température maximale atteinte par le composant lors d'une surcharge thermique.

Pour toutes les représentations graphiques des figures 4A à 4D, $T_{max}$ - $T_{nominale}$ = 10°C.

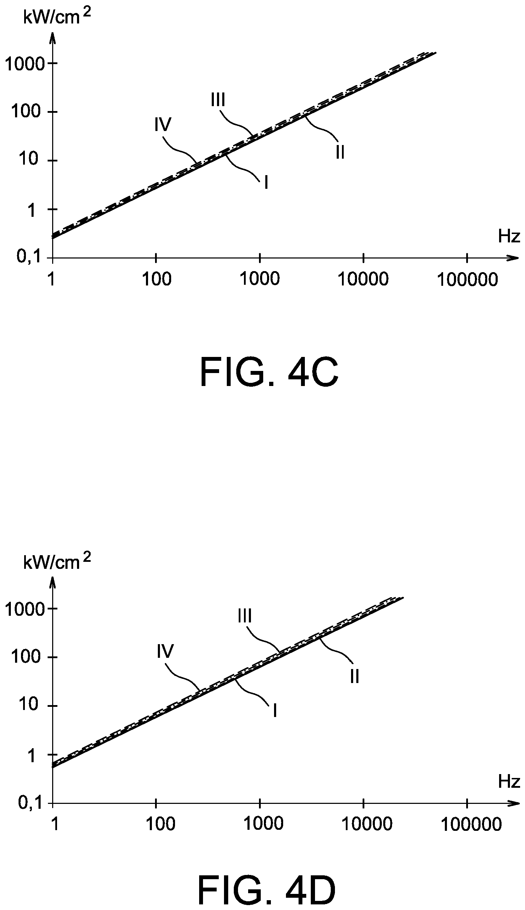

Pour la figure 4A, H = 50 $\mu$m, pour la figure 4B, H = 100 $\mu$m, pour la figure 4C, H = 500 $\mu$m et pour la figure 4D, H = 1 mm.

Les matériaux considérés sont :

I : Erythriol dont la température de fusion est 118°C ;
II : PlusICEX180® fabriqué par PCMprocess dont la température de fusion est 180°C ;
III : A164® fabriqué par PCMprocess dont la température de fusion est 164C :
IV : H110® fabriqué par PCMprocess dont la température de fusion est 110°C.

La densité surfacique de puissance stockable est le produit de la densité surfacique d'énergie stockable par la fréquence de la surcharge thermique. Celle-ci est présentée sur les courbes ci-dessous pour un intervalle de température $T_{max}$ - $T_{MCP}$ de 10 °C et divers épaisseurs de matériaux à changement de phase.

On constate :

- qu'une épaisseur de 50 $\mu$m de matériau à changement de phase peut stocker environ 0,3 kW/cm$^2$ à 100 Hz, 3 kW/cm$^2$ à 1 kHz, 30 kW/cm$^2$ à 10 kHz et 300 kW/cm$^2$ à 100 kHz ;
- qu'une épaisseur de 100 $\mu$m de matériau à changement de phase peut stocker 2 fois la puissance stockable avec une épaisseur de 50 $\mu$m ;
- qu'une épaisseur de 500 $\mu$m de matériau à changement de phase peut stocker 10 fois la puissance stockable avec une épaisseur de 50 $\mu$m ;
- qu'une épaisseur de 1000 $\mu$m de matériau à changement de phase peut stocker 20 fois la puissance stockable avec une épaisseur de 50 $\mu$m.

Sur les figures 5A à 5C, est représentée l'évolution de la profondeur de pénétration thermique en $\mu$m en fonction de la fréquence de la charge thermique en régime transitoire.

La profondeur de pénétration thermique est la profondeur jusqu'à laquelle le matériau à changement de phase passe à l'état liquide. En connaissant cette profondeur, il est possible d'optimiser la taille des cellules de sorte que la quantité de matériau à changement de phase correspond au stockage de la chaleur dans le cas d'une surcharge thermique.

A l'échelle du matériau à changement de phase contenu dans une cellule, la chaleur est conduite au sein du matériau à changement de phase. La cinétique du transport de la chaleur au sein du matériau à changement de phase dépend alors des conditions de température sur les parois des cellules et des propriétés physiques du matériau à changement de phase

$$s(t) = \sqrt{2 \frac{\lambda \Delta T}{L} t} \quad \text{(I)}$$

où s(t) est la position du front de changement de phase (ou profondeur de pénétration thermique) à l'instant t,
$\lambda$ est la conductivité thermique du matériau à changement de phase en W/k.m,
$\Delta T$ la différence de température entre les parois de la cellule et le matériau à changement de phase non transformé,
L la chaleur latente de changement de phase du matériau à changement de phase en J/m$^3$.

A l'échelle du dispositif de stockage, la chaleur est conduite le long des parois en nanotubes de carbone. La cinétique du transport dépend alors du flux de chaleur incident, de l'architecture et des propriétés physiques du réseau de cellule. Statistiquement, une profondeur moyenne de pénétration thermique peut être définie comme suit :

$$\delta(\omega) = \sqrt{\frac{2.D}{\omega}} \quad \text{(II)}$$

où D est la diffusivité thermique du matériau en m$^2$/s et $\omega$ la fréquence du signal thermique.

Dans les représentations graphiques des figures 5A à 5C, on peut voir les profondeurs de pénétration de la chaleur dans les matériaux à changement de phase I, II, III et IV, dans les nanotubes de carbone (courbe V), et dans le cuivre (courbe VI) à titre de référence.

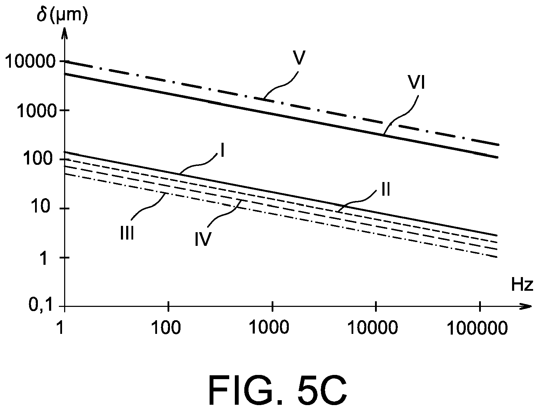

Pour toutes les figures la température nominale est 90°C. Pour la figure 5A, $\Delta T = 1$°C, pour la figure 5B, $\Delta T = 10$°C et pour la figure 5C, $\Delta T = 20$°C.

La lecture des courbes des figures 5A à 5C permet de déterminer la taille des cellules afin que tout le matériau à changement de phase soit fondu en cas de surcharge thermique.

On constate donc que, pour que tout le matériau à changement de phase soit fondu :

- pour une $\Delta T$ de 1°C et selon le matériau à changement de phase, la taille de cellule optimale est comprise entre 3 $\mu$m et 10 $\mu$m pour une fréquence de la surcharge thermique inférieure ou égale à 100 Hz ;
- pour un $\Delta T$ de 1°C et selon le matériau à changement de phase, la taille de cellule optimale est comprise entre 1 à 3 $\mu$m de taille pour une fréquence de la surcharge thermique inférieure ou égale à 1 kHz ;
- pour une $\Delta T$ de 1°C et selon le matériau à changement de phase, la taille de cellule optimale est comprise entre 0,3 à 1 $\mu$m pour une fréquence de la surcharge thermique inférieure ou égale à 10 kHz ;
- pour un $\Delta T$ de 1°C et selon le matériau à changement de phase, la taille de cellule optimale est comprise entre 0,1 à 0,3 $\mu$m pour une fréquence de la surcharge thermique inférieure ou égale à 100 kHz ;
- pour une $\Delta T$ de 10°C et selon le matériau à changement de phase, la taille de cellule optimale est comprise entre 10 à 30 $\mu$m pour une fréquence de la surcharge thermique inférieure ou égale à 100 Hz ;
- pour un $\Delta T$ de 10°C et selon le matériau à changement de phase, la taille de cellule optimale est comprise entre 3 à 10 $\mu$m pour une fréquence de la surcharge thermique inférieure ou égale à 1 kHz ;
- pour un $\Delta T$ de 10°C et selon matériau à changement de phase, la taille de cellule optimale est comprise entre 1 à 3 $\mu$m pour une fréquence de la surcharge thermique inférieure ou égale à 10 kHz ;
- pour un $\Delta T$ de 10°C et selon le matériau à changement de phase, la taille de cellule optimale est comprise entre 0,3 à 1 $\mu$m) pour une fréquence de la surcharge thermique inférieure ou égale à 100 kHz ;
- pour un $\Delta T$ de 20°C et selon le matériau à changement de phase, la taille de cellule optimale est comprise entre 15 à 45 $\mu$m pour une fréquence de la surcharge thermique inférieure ou égale à 100 Hz ;
- pour un $\Delta T$ de 20°C et selon le matériau à changement de phase, la taille de cellule optimale est comprise entre 3 à 10 $\mu$m pour une fréquence de la surcharge thermique inférieure ou égale à 1 kHz ;
- pour un $\Delta T$ de 20°C et selon le matériau à changement de phase, la taille de cellule optimale est comprise entre 1 à 3 $\mu$m pour une fréquence de la surcharge thermique inférieure ou égale à 10 kHz ;
- pour un $\Delta T$ de 20°C et selon le matériau à changement de phase, la taille de cellule optimale est comprise entre 0,3 à 1 $\mu$m de taille pour une fréquence de la surcharge thermique inférieure ou égale à 100 kHz.

Nous allons maintenant décrire des exemples de procédé de réalisation d'un dispositif de gestion thermique selon l'invention dont les étapes sont représentées schématiquement sur les figures 2A à 3D.

Sur les figures 2A et 2B, on peut voir un premier exemple d'un procédé de réalisation dans lequel le réseau de cellules est réalisé sur le capot.

Lors d'une première étape, on réalise une cavité 16 dans un support 14 en matériau conducteur thermique, par exemple en silicium monocristallin. La cavité 16 est réalisée par exemple par gravure chimique en phase aqueuse, par exemple avec du KOH, ou par gravure sèche profonde, par exemple par gravure ionique réactive (ou RIE pour Reactive-Ion Etching).

L'épaisseur du substrat est par exemple de l'ordre de 0,5 mm à 1 mm. La profondeur de la cavité 16 est de l'ordre de 50 $\mu$m à 500 $\mu$m. L'aire des cavités est typiquement comprise entre 1000 $\mu$m2 et 100 cm$^2$.

De manière avantageuse, une couche de métal ductile (non représentée) est déposée en fond de cavité 16 afin d'assurer un contact physique et thermique avec les nanotubes de carbones qui seront disposés par la suite dans la cavité. Cette couche peut être déposée par dépôt physique en phase vapeur, dépôt chimique en phase vapeur, Electroplating,... elle peut être en titane, en or, en cuivre, en aluminium, ... Son épaisseur est typiquement comprise entre 10 nm et 10 $\mu$m.

Cette structure est visible sur la figure 2A.

Lors d'une étape suivante, on réalise le réseau de cellules sur le capot tel que visible sur la figure 2A.

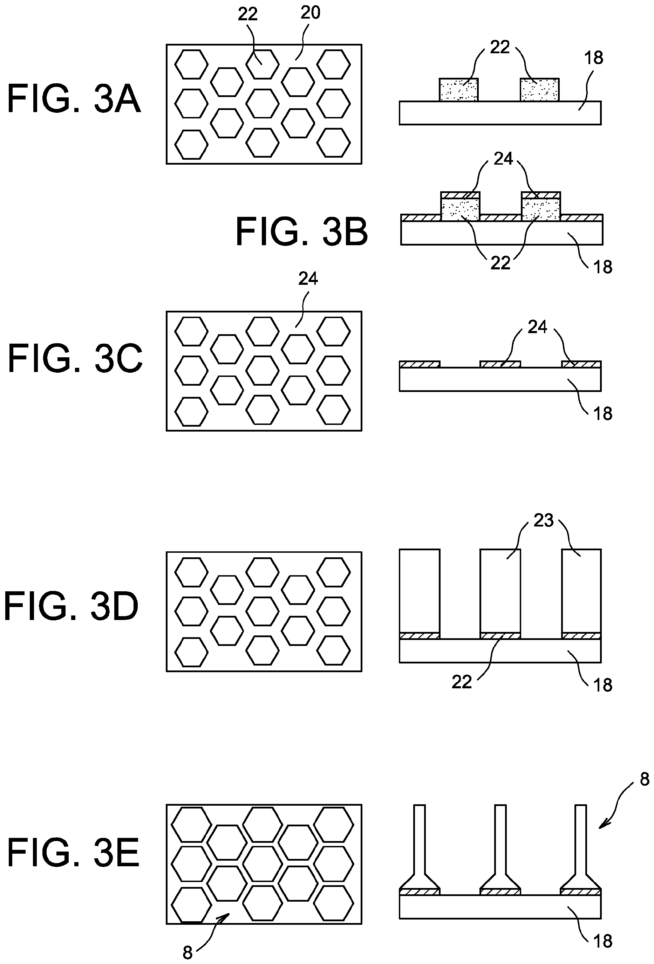

Pour cela, on dépose une couche de résine 22 sur une face du capot 18 et on effectue une lithographie du motif à réaliser (figure 3A). Dans le cas représenté, il s'agit d'un motif en nid d'abeille.

Lors d'une étape suivante (figure 3B), on effectue un dépôt d'un catalyseur 24 par dépôt physique en phase vapeur. Le catalyseur 24 est par exemple une couche de fer, comprise entre 0,5 nm et 10 nm, de préférence égale à 1 nm ou un système bicouches comportant une couche d'aluminium de 10 nm et d'une couche de fer de 1 nm.

Lors d'une étape suivante, on effectue un retrait de la résine 22 (figure 3C).

Lors d'une étape suivante, on fait croître des nanotubes 23 par dépôt chimique en phase vapeur thermique

avec un mélange $C_2H_2$, $H_2$, He avec des flux gazeux de 10, 50, 50 cm$^3$/min par exemple à une température comprise entre 550°C et 750°C a une pression comprise entre 0,1 mbar et 10 mbar. La hauteur des tubes est fixée par le temps de croissance (figure 3D).

Lors d'une étape suivante avantageuse, on réalise une compaction des tubes par immersion dans une solution d'alcool. Lors du séchage à l'air, les parois en nanotubes collapsent et forment un matériau dense dans lequel les nanotubes sont en contact (figure 3E).

Le réseau de cellules 8 est formé.

Lors d'une étape suivante on remplit la cavité avec du matériau à changement de phase 12.

Enfin on reporte le capot 18 muni du réseau de cellules 8 sur la cavité 16, le réseau pénétrant dans la cavité 16. Et on effectue un scellement du capot 18 sur le support 14. Un joint 26 est prévu entre le capot et le support.

Sur les figure 2A' et 2B', on peut voir un autre exemple de procédé de réalisation dans lequel on réalise le réseau de cellules 10 directement dans la cavité 16.

Tout d'abord on réalise une cavité 16 dans un support 14 comme décrit précédemment.

On effectue les étapes 3A à 3E sur le fond de la cavité 16. La hauteur des nanotubes de carbone est proche de la profondeur de la cavité 16, sensiblement inférieure ou sensiblement supérieure.

On remplit ensuite la cavité 16 avec un matériau à changement de phase 10.

De préférence, une couche de métal (non représentée) présentant une certaine ductilité est déposée localement sur le capot 18 afin d'assurer un contact physique et thermique entre les nanotubes et le capot 18. Cette couche est réalisée comme décrit précédemment.

Enfin on reporte le capot 18 sur le support 14 pour obturer la cavité 16. Et on effectue un scellement du capot 18 sur le support 14. Un joint 26 est prévu entre le capot 18 et le support 14.

Le dispositif réalisé par les procédés décrits précédemment ne comporte qu'une cavité, mais il est bien entendu que les étapes de fabrication décrites précédemment s'appliquent pour réaliser des dispositifs comportant plusieurs cavités tels que représentés sur les figures 1A et 1C.

Le dispositif de gestion thermique est reporté sur un composant électronique par des techniques de la microélectronique bien connues de l'homme du métier.

Le dispositif de gestion thermique selon l'invention permet donc de gérer thermiquement des sources de chaleur transitoires ou intermittentes, en particulier dan les systèmes électronique 3D, par exemple pour former un dispositif intégré dans des composants électroniques mettant en oeuvre des via traversants ou TSV.

## Revendications

1. Dispositif de gestion thermique comportant une première face (4) destinée à être en contact avec une source chaude (SC) et une deuxième face (6) opposée à la première destinée à être en contact avec une source froide (SF), au moins un réseau de cellules (8) remplies d'un matériau à changement de phase solide/liquide (10) disposé entre la première (4) et la deuxième face (6), les cellules comportant des parois formées de nanotubes de carbone, lesdits nanotubes s'étendant sensiblement de la première (4) à la deuxième (6) face et reliant thermiquement la première face (2) à la deuxième face (4), les parois des cellules étant formées des nanotubes en contact de sorte à former un matériau dense.

2. Dispositif de gestion thermique selon la revendication 1, dans lequel les parois des cellules forment une cloison latérale continue.

3. Dispositif de gestion thermique selon l'une des revendications 1 ou 2, dans lequel la dimension transversale de chaque cellule est inférieure ou égale à la distance du front de fusion, la distance du front de fusion étant de l'ordre

   de $\sqrt{\dfrac{2.k.\Delta T.t}{L}}$, k étant la conduction thermique du matériau à changement de phase, L étant la chaleur latente de fusion du matériau à changement de phase, $\Delta T$ étant la différence de température entre la température de la paroi d'une cellule lors d'une surcharge thermique et la température de changement de phase du matériau à changement de phase, et t étant le temps.

4. Dispositif de gestion thermique selon l'une des revendications 1 à 3, comportant un support (14) muni d'au moins une cavité (16) et un capot (18) obturant ladite cavité (18), ladite cavité (18) comportant un réseau de cellules (8) en nanotubes de carbone remplies de matériau à changement de phase (10).

5. Dispositif de gestion thermique selon la revendication 4, comportant un matériau conducteur thermique ductile interposé entre le capot (18) et le réseau de cellules (8) ou entre le fond de la cavité (16) et le réseau de cellules (8).

6. Dispositif de gestion thermique selon la revendication 5, dans lequel le réseau de cellules (8) est solidaire du capot (18) ou le réseau de cellules (8) est solidaire du fond de la cavité (16).

7. Dispositif de gestion thermique selon l'une des revendications 4 à 6, comportant plusieurs cavités (16).

8. Dispositif de gestion thermique selon l'une des revendications 4 à 7, dans lequel l'aire de la ou les cavités (16) est comprise entre 1000 $\mu m^2$ et 10 $cm^2$.

9. Dispositif de gestion thermique selon l'une des revendications 4 à 8, dans lequel le support (14) a une épaisseur comprise entre 0,5 mm et 1 mm, de préférence égal à 750 $\mu$m, et la ou les cavités 16 ont une profondeur comprise entre 50 $\mu$m et 500 $\mu$m.

10. Système électronique comportant au moins un composant électronique formant une source de chaleur (SC), au moins un dispositif d'évacuation de la chaleur formant une source froide (SF) et au moins un dispositif de gestion thermique selon l'une des revendications 1 à 9, le composant électronique étant en contact thermique avec la première face (4) du dispositif de gestion thermique et le dispositif d'évacuation de la chaleur étant en contact thermique avec la deuxième face (6).

11. Procédé de fabrication d'un dispositif de gestion thermique selon l'une des revendications 1 à 9, comportant les étapes :

    a) définition du motif du réseau de cellules sur un substrat par dépôt de résine (22) et lithographie de celle-ci,
    b) dépôt d'une couche de catalyseur (24), par exemple une couche de fer ou d'un système bicouche aluminium et fer.
    c) retrait de la résine (22),
    d) croissance des nanotubes de carbone, par dépôt chimique en phase vapeur,
    e) remplissage des cellules avec le matériau à changement de phase (10).

12. Procédé de fabrication selon la revendication 11, comportant une étape de compactage de nanotubes de carbone par immersion dans une solution d'alcool du réseau de cellules et séchage à l'air.

13. Procédé de fabrication selon la revendication 11 ou 12, comportant, préalablement au étapes a) à d), les étapes de réalisation de une ou plusieurs cavités (16) dans un support (14), la ou lesdites cavités (16) recevant un réseau de cellules (8), et après l'étape d) de fermeture de la ou des cavités par un capot (18).

14. Procédé de fabrication selon la revendication 13, dans lequel le substrat est formé par le fond de la ou des cavités (16) et dans lequel les étapes a) à d) ont lieu sur le fond de la ou des cavités (16), le procédé comportant avantageusement une étape de dépôt d'une couche de matériau conducteur thermique ductile sur le fond de la ou des cavités destinée à être orientée vers l'intérieur de la cavité.

15. Procédé de fabrication selon la revendication 13, dans lequel le substrat est formé par le capot (18) et dans lequel les étapes a) à d) ont lieu sur le capot, le procédé comportant avantageusement une étape de dépôt d'une couche de matériau conducteur thermique ductile sur une face de capot destinée à être orientée vers l'intérieur de la cavité.

**Patentansprüche**

1. Wärmeverwaltungsvorrichtung, umfassend eine erste Fläche (4), die dazu ausgelegt ist, in Kontakt mit einer heißen Quelle (SC) zu sein, sowie eine zweite Fläche (6) entgegengesetzt zur ersten, die dazu ausgelegt ist, in Kontakt mit einer kalten Quelle (SF) zu sein, wobei zwischen der ersten (4) und der zweiten Fläche (6) wenigstens ein Netz von Zellen (8) angeordnet ist, die mit einem Fest/Flüssig-Phasenänderungsmaterial (10) gefüllt sind, wobei die Zellen Wände umfassen, die aus Kohlenstoffnanoröhrchen gebildet sind, wobei sich die Röhrchen im Wesentlichen von der ersten (4) zu der zweiten (6) Fläche erstrecken und die erste Fläche (2) thermisch mit der zweiten Fläche (4) verbinden, wobei die Wände der Zellen aus Nanoröhrchen in Kontakt miteinander derart gebildet sind, dass ein dichtes Material gebildet ist.

**2.** Wärmeverwaltungsvorrichtung nach Anspruch 1, bei der die Wände der Zellen eine durchgehende laterale Wandung bilden.

**3.** Wärmeverwaltungsvorrichtung nach einem der Ansprüche 1 oder 2, bei der die transversale Abmessung jeder Zelle kleiner oder gleich dem Abstand von der Schmelzfront ist, wobei der Abstand von der Schmelzfront in der Größenordnung von $\sqrt{\dfrac{2.k.\Delta T.t}{L}}$ ist, wobei k die Wärmeleitung des Phasenänderungsmaterials ist, wobei L die latente Schmelzwärme des Phasenänderungsmaterials ist, wobei $\Delta T$ die Temperaturdifferenz ist zwischen der Wandtemperatur einer Zelle während einer thermischen Überladung und der Phasenänderungstemperatur des Phasenänderungsmaterials, und wobei t die Zeit ist.

**4.** Wärmeverwaltungsvorrichtung nach einem der Ansprüche 1 bis 3, umfassend einen Träger (14), der mit wenigstens einem Hohlraum (16) und einem Deckel (18) ausgestattet ist, der den Hohlraum (18) verschließt, wobei der Hohlraum (18) ein Netz von Zellen (8) aus Kohlenstoffnanoröhrchen umfasst, die mit Phasenänderungsmaterial (10) gefüllt sind.

**5.** Wärmeverwaltungsvorrichtung nach Anspruch 4, umfassend ein duktiles Wärmeleitermaterial, das zwischen dem Deckel (18) und dem Netz von Zellen (8) oder zwischen dem Boden des Hohlraums (16) und dem Netz von Zellen (8) eingefügt ist.

**6.** Wärmeverwaltungsvorrichtung nach Anspruch 5, wobei das Netz von Zellen (8) mit dem Deckel (18) verbunden ist, oder wobei das Netz von Zellen (8) mit dem Boden des Hohlraums (16) verbunden ist.

**7.** Wärmeverwaltungsvorrichtung nach einem der Ansprüche 4 bis 6, umfassend mehrere Hohlräume (16).

**8.** Wärmeverwaltungsvorrichtung nach einem der Ansprüche 4 bis 7, wobei der Inhalt des Hohlraums oder der Hohlräume (16) zwischen 1000 $\mu m^2$ und 10 $cm^2$ enthalten ist.

**9.** Wärmeverwaltungsvorrichtung nach einem der Ansprüche 4 bis 8, wobei der Träger (14) eine Dicke hat, die zwischen 0,5 mm und 1 mm enthalten ist, vorzugsweise gleich 750 $\mu m$, und wobei der Hohlraum oder die Hohlräume (16) eine Tiefe hat/haben, die zwischen 50 $\mu m$ und 500 $\mu m$ enthalten ist.

**10.** Elektronisches System, umfassend wenigstens eine elektronische Komponente, die eine Wärmequelle (SC) bildet, wenigstens eine Vorrichtung zur Ableitung der Wärme, die eine kalte Quelle (SF) bildet, sowie wenigstens eine Wärmeverwaltungsvorrichtung nach einem der Ansprüche 1 bis 9, wobei die elektronische Komponente in Wärmekontakt mit der ersten Fläche (4) der Wärmeverwaltungsvorrichtung ist, und wobei die Vorrichtung zur Ableitung der Wärme in Wärmekontakt mit der zweiten Fläche (6) ist.

**11.** Verfahren zur Herstellung einer Wärmeverwaltungsvorrichtung nach einem der Ansprüche 1 bis 9, umfassend die folgenden Schritte:

a) Definieren des Motivs des Netzes von Zellen auf einem Substrat durch Aufbringen von Harz (22) und Lithographie desselben,
b) Aufbringen einer Katalysatorschicht (24), beispielsweise einer Schicht aus Eisen oder eines Zweischichtsystems aus Aluminium und Eisen,
c) Entfernen des Harzes (22),
d) Aufwachsen der Kohlenstoffnanoröhrchen durch chemische Dampfphasenabscheidung,
e) Füllen der Zellen mit dem Phasenänderungsmaterial (10).

**12.** Herstellungsverfahren nach Anspruch 11, umfassend einen Schritt des Kompaktierens von Kohlenstoffnanoröhrchen durch Eintauchen des Netzes von Zellen in eine Alkohollösung und Trocknen an Luft.

**13.** Herstellungsverfahren nach Anspruch 11 oder 12, umfassend vor den Schritten a) bis d) die Schritte der Realisierung von einem oder mehreren Hohlräumen (16) in einem Träger (14), wobei der Hohlraum oder die Hohlräume (16) ein Netz von Zellen (8) aufnehmen, sowie nach dem Schritt d) des Schließens des Hohlraums oder der Hohlräume durch einen Deckel (18).

**14.** Herstellungsverfahren nach Anspruch 13, wobei das Substrat durch den Boden des Hohlraums oder der Hohlräume (16) gebildet ist, und wobei die Schritte a) bis d) auf dem Boden des Hohlraums oder der Hohlräume (16) erfolgen, wobei das Verfahren vorzugsweise einen Schritt des Aufbringens einer Schicht aus duktilem Wärmeleitermaterial auf dem Boden des Hohlraums oder der Hohlräume umfasst, die zum Inneren des Hohlraums orientiert sein soll.

**15.** Herstellungsverfahren nach Anspruch 13, wobei das Substrat durch den Deckel (18) gebildet ist, und wobei die Schritte a) bis d) auf dem Deckel erfolgen, wobei das Verfahren vorzugsweise einen Schritt des Aufbringens einer Schicht aus duktilem Wärmeleitermaterial auf einer Fläche des Deckels umfasst, die zum Inneren des Hohlraums hin orientiert sein soll.


**Claims**

**1.** A thermal management device comprising a first face (4) intended to be in contact with a hot source (SC) and a second face (6) opposite the first face intended to be in contact with a cold source (SF), at least one network of cells (8) filled with a solid/liquid phase-change material (10) positioned between the first (4) and second (6) faces, where the cells comprise walls formed of carbon nanotubes, where the said nanotubes extend roughly from the first (4) to the second (6) face, thermally connecting the first face (2) to the second face (4), and where the walls of the cells are formed from nanotubes in contact so as to form a dense material.

**2.** A thermal management device according to claim 1, in which the walls of the cells form a continuous lateral partition.

**3.** A thermal management device according to either of claims 1 or 2, in which the transverse dimension of each cell is less than or equal to the melt front distance, where the melt front distance is of the order of $\sqrt{\dfrac{2.k.\Delta T.t}{L}}$, where k is the thermal conduction of the phase-change material, L is the latent heat of fusion the phase-change material, $\Delta T$ is the temperature difference between the temperature of the wall of a cell during a thermal overload and the phase-change temperature of the phase-change material, and t is the time.

**4.** A thermal management device according to one of claims 1 to 3, comprising a support (14) with at least one cavity (16) and a cover (18) sealing the said cavity (18), where the said cavity (18) comprises a network of cells (8) made of carbon nanotubes filled with phase-change material (10).

**5.** A thermal management device according to claim 4, comprising a ductile thermal conductive material interposed between the cover (18) and the network of cells (8) or between the base of the cavity (16) and the network of cells (8).

**6.** A thermal management device according to claim 5, in which the network of cells (8) is fixed to the cover (18) or the network of cells (8) is fixed to the base of the cavity (16).

**7.** A thermal management device according to one of claims 4 to 6, comprising several cavities (16).

**8.** A thermal management device according to one of claims 4 to 7, in which the area of the cavity or cavities (16) is between 1000 $\mu m^2$ and 10 $cm^2$.

**9.** A thermal management device according to one of claims 4 to 8, in which the support (14) is between 0.5 mm and 1 mm thick, preferably 750 $\mu$m thick, and the depth of cavity or cavities 16 is between 50 $\mu$m and 500 $\mu$m.

**10.** An electronic system comprising at least one electronic component forming a heat source (SC), at least one heat evacuation device forming a cold source (SF) and at least one thermal management device according to one of claims 1 to 9, where the electronic component is in thermal contact with the first face (4) of the thermal management device and the heat evacuation device is in thermal contact with the second face (6).

**11.** A method for manufacturing a thermal management device according to one of claims 1 to 9, comprising the following steps:

a) definition of the pattern of the network of cells on a substrate by deposition of resin (22) and lithography of it,

b) deposition of a catalyst layer (24), for example a layer iron or an aluminium and iron bilayer system,
c) removal of the resin (22),
d) growth of the carbon nanotubes, by chemical vapour deposition,
e) filling of the cells with the phase-change material (10).

12. A manufacturing method according to claim 11, comprising a step of compacting of carbon nanotubes by immersing the network of cells in alcohol solution, and drying it in air.

13. A manufacturing method according to claim 11 or 12, comprising, prior to steps a) to d), the steps of production of one or more cavities (16) in a support (14), where the said cavity or cavities (16) receive a network of cells (8), and after step d) of closure of the cavity or cavities by a cover (18).

14. A manufacturing method according to claim 13, in which the substrate is formed by the base of the cavity or cavities (16) and in which steps a) to d) take place on the base of the cavity or cavities (16), the method advantageously comprising a step of deposition of a layer of ductile thermal conductive material on the base of the cavity or cavities intended to be pointing towards the interior of the cavity.

15. A manufacturing method according to claim 13, in which the substrate is formed by the cover (18), and in which steps a) to d) take place on the cover, the method advantageously comprising a step of deposition of a layer of ductile thermal conductive material on a cover face intended to be pointing towards the interior of the cavity.

SC

14 ←

10   F↓   4

16   8   12   6

2 →

SF

# FIG. 1A

8

2 →

14

10

16   12

# FIG. 1B

SC   8   8   SC

19   19

14   18

16   10

19   10

SC   SF

# FIG. 1C

FIG. 2A

FIG. 2B

FIG. 2A'

FIG. 2B'

EP 2 803 085 B1

FIG. 3A

FIG. 3B

FIG. 3C

FIG. 3D

FIG. 3E

FIG. 4A

FIG. 4B

FIG. 4C

FIG. 4D

FIG. 5A

FIG. 5B

FIG. 5C

**EP 2 803 085 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060231970 A
- US 2008174963 A